# EUROPEAN PATENT SPECIFICATION

(11) **EP 1 915 043 B1**
(45) Date of publication and mention of the grant of the patent: **09.09.2009**
(21) Application number: 06122447.3
(22) Date of filing: 17.10.2006
(51) Int. Cl.: H05K 7/12, H05K 3/30

(54) **Apparatus for fastening a component on a circuit board**
Vorrichtung zur Befestigung eines elektrischen Bauteils auf einer Leiterplatte
Dispositif pour fixer un composant sur un circuit imprimé

(43) Date of publication of application: 23.04.2008
(73) Proprietor: Delphi Technologies, Inc., Troy, MI 48007 (US)
(72) Inventor: Kerr, Geoffrey, Ormskirk, Lancashire L39 3NU (GB)
(74) Representative: Denton, Michael John

(56) References cited:
- WO-A-98/37447
- JP-A- 63 124 556
- US-A1- 2003 093 897
- US-A1- 2003 103 337

## Description

The present invention is concerned with circuit component locating apparatus, particularly, but not exclusively, with circuit component locating apparatus used to locate a component on a circuit board in an improved manner.

Circuit boards are widely used in many industries. For example, they are used in Engine Control Unit (ECUs) or Engine Control Modules (ECMs) in automobiles etc. The boards typically have a solid support board on which a number of electrical components are mounted. The dimensions (length, width diameter etc.) of the components varies widely depending upon the purpose of the overall circuit. A problem with relatively large components is that they can be vulnerable to forces from vibration / impact from the surrounding environment (this is particularly true in circuits boards used in ECUs and ECMs of automobiles where vibrations are produced by the engine / chassis).

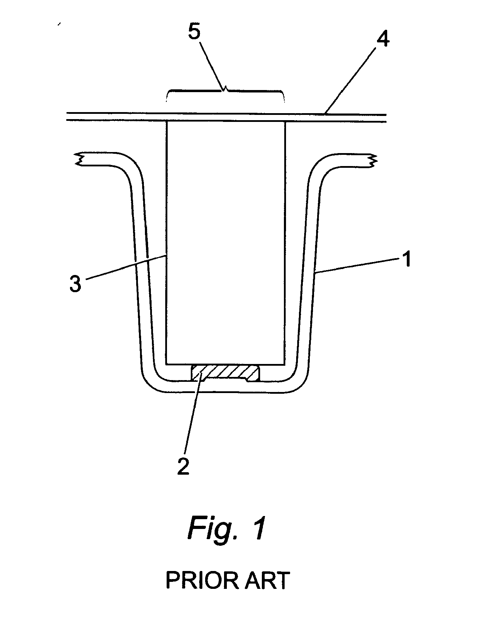

Circuit boards are often surrounded by a case which protects the components from contaminants. With reference to Fig. 1, the protective case also ensures that the components are not displaced due to vibrational forces. This is achieved by dispensing an adhesive 2 into the bottom of the case 1. The component 3, which is attached to a circuit board 4 by soldered joints 5, is then pressed into the adhesive 2 in order to provide an adhesive connection between the top of the component 3 and the bottom of the case 1. The adhesive is then typically cured by heating and subsequent cooling of the entire arrangement.

A problem with this method of securing the component is that both the case 1 and adhesive 2 have a tendency to expand, during the curing operation, and contract when they cool (or when the vehicle is used in a cold climate). Since the adhesive 2 is positioned on top of the component 3, any expansion and contraction of the adhesive 2 exerts forces on the component and thus the soldered joints 5 between the component 3 and the circuit board 4. This can eventually lead to failure of the soldered joint and hence failure of the entire circuit board.

Another method of securing components to a circuit board is described in Japanese Patent Publication No. 63124556 (Hitachi Ltd.). This arrangement attempts to address the problem of stress placed on the join location between circuit components and a circuit board. The arrangement secures the components by way of a frame having a matched co-efficient of thermal expansion; however this arrangement has its own disadvantages.

Another method of securing components is described in publication WO 98/37447.

According to the present invention there is provided circuit component locating apparatus for locating a circuit component on a circuit board, and a method of locating a circuit component on a circuit board, as defined in the claims.

Other preferred features and advantages of the invention will be apparent from the following description and the claims.

Embodiments of the invention will now be described, by way of example only, with reference to the drawings, in which:-
Fig. 1 is a partial cross sectional view of a prior art arrangement which is not in accordance with the invention. In this arrangement an outer case surrounds the component. Adhesive is provided between the top of the component and the bottom of the case;
Fig. 2 is a perspective view of an embodiment of the apparatus in accordance with the present invention viewed from above, where the apparatus locates a cylindrical circuit component;
Fig. 3 is a perspective view of the apparatus of Fig. 1 from one side, where a cover plate is positioned around the cylindrical circuit component;
Fig. 4A is a transverse cross sectional view of the apparatus of Fig. 2; and
Fig. 4B is a transverse cross sectional view of the apparatus of Fig. 2 with the cover plate positioned around the cylindrical circuit component.

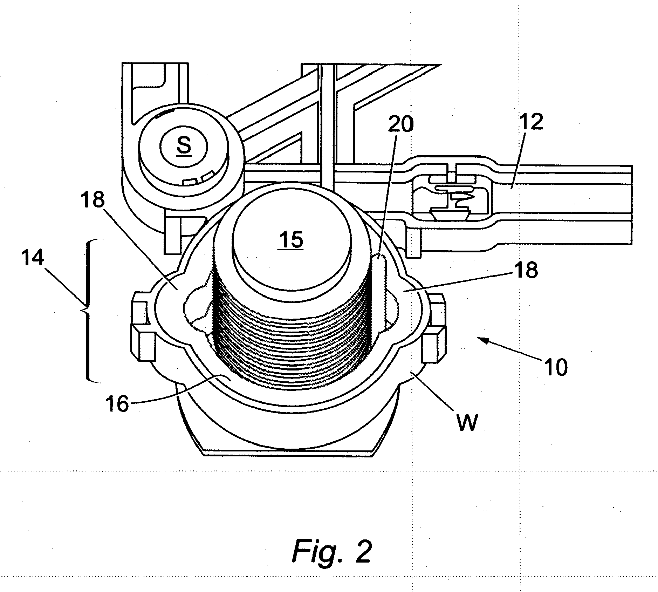

With reference to Fig. 2 circuit component locating apparatus 10 includes a fastening frame 12 having an extension 14 projecting therefrom. The fastening frame 12 is in the form of a discrete frame member which can be attached to a circuit board with a number of locating rivets or screws S. The extension 14 has an aperture therethrough which is shaped to accept a correspondingly shaped circuit component 15. In the embodiment shown the aperture is circular in order to accept a cylindrical circuit component 15, although it will be appreciated that the aperture could be any shape corresponding to a cross sectional shape of the circuit component 15, for example, rectangular, square, triangular etc. The aperture is slightly larger than the circuit component around which it is to be placed in order to provide a space in which adhesive means, such as glue, may be provided. The size of the aperture can also be increased to aid positioning of the frame over the circuit component 15 by accepting manufacturing tolerances in the dimensions of the circuit component 15.

An attachment member, or wall W, is provided around the aperture and has a lip at the opening of the aperture. The lip is angled relative to the central axis of the aperture in order to form a ledge 16. The ledge 16 is also contoured at locations 18 in order to maintain a substantially constant space between the wall W and the circuit component 15 taking account of any projecting connections 20 on the circuit component 15. As shown in Fig. 2, a redundancy may be incorporated into the apparatus by providing the contoured sections 18 at either side of the component 15. This also allows the apparatus to fit properly over a component which is attached to the circuit board in the opposite direction (rotated through an angle of 180 degrees).

In use, the apparatus 10 is placed over the various components of the circuit board, ensuring that each aperture of each extension 14 is placed around each circuit component. Once in position over the circuit components, the fastening frame 12 is then secured to the circuit board by locating screws S. In order to secure, the circuit components 15 to the fastening frame 12 (and hence relative to the circuit board) an adhesive is applied around the ledge 16. The angle of the ledge 16 is oriented such that the adhesive begins to flow toward the component 15 and into engagement with both the inner side surface of the wall W and the outer side surface of the circuit component 15 adjacent the wall W. In the present embodiment the ledge is angled at 45 degrees; however, any angle capable of providing the desired function may be used.

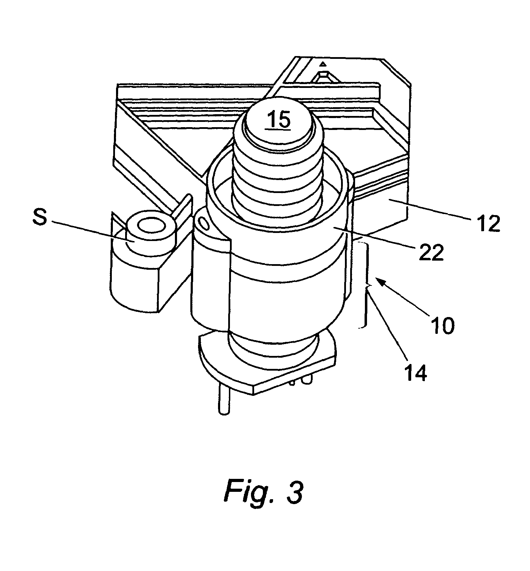

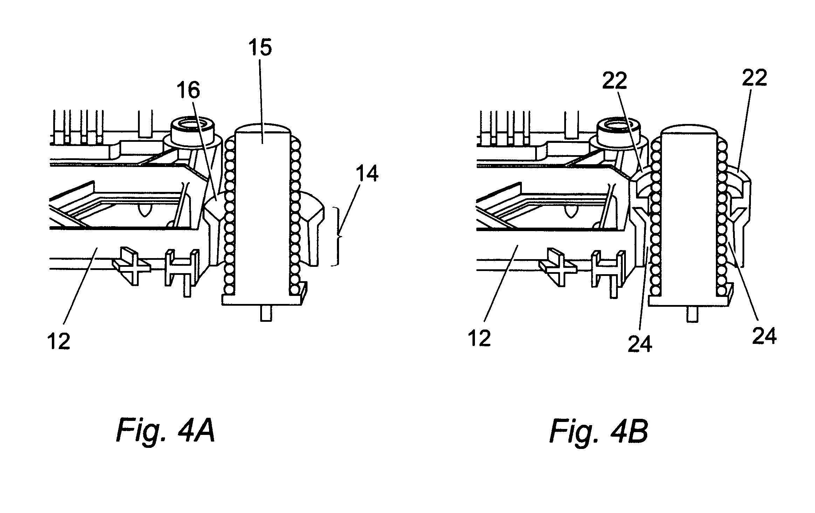

With reference to Fig. 3, some adhesives do not flow easily and may not flow into engagement with the circuit component. To overcome this, a cover plate 22 is placed around the circuit component 15. The cover plate may be a separate member or may be integrated into the apparatus by way of a hinge (not shown) which allows it to simply flip over the circuit component from a storage position to an active position. The cover plate 22 is then progressed down the circuit component until a snap fit connection is formed between the cover plate 22 and the wall ledge 16. This causes any adhesive residing on the ledge 16 to be pushed down into the space between the wall W and circuit component 15. In this regard, the lower face of the cover plate 22 is shaped to correspond with the ledge of the wall W. The final position of the adhesive is referenced 24 in Fig. 4B. When in position, the cover plate also has the additional effect of sealing the top of the space between the wall and circuit component. Furthermore, the inner shape of the cover plate may be such that it fits closely around the circuit component 15 and provides some additional lateral support to the circuit component 15.

The apparatus described allows an adhesive connection to be provided between the side of the circuit component and the wall. With such an arrangement, the effect of any expansion and contraction of the adhesive on the soldered joints of the circuit component is minimised.

The arrangement securely attaches the circuit components to the circuit board and therefore eliminates the need for securing the components using the casing. This further eliminates any stress on the circuit component soldered joints which would otherwise be caused by the interaction between the casing and the components during expansion and contraction.

Modifications, and improvements may be made to the foregoing without departing from the scope of the invention, for example:-
Although the apparatus in the embodiment shown in Figs. 2 to 4 is incorporated into a discrete frame member 12, alternatively, the apparatus may be provided directly onto a circuit board.

## Claims

1. Circuit component locating apparatus for locating a circuit component on a circuit board, the circuit component locating apparatus comprising:-
a fastening frame (12);
an attachment member (14) projecting from the fastening frame (12), having an aperture, and extending, in use, at least partially around a side face of the located circuit component (15), wherein, in use, the attachment member (14) is spaced apart from the located circuit component (15) in order to define a space between the attachment member (14) and said side face of the circuit component (15), **characterised in that** the space is capable of receiving adhesive means and the attachment member(14) is angled relative to the longitudinal axis of the aperture in order to provide a ledge (16) for urging the adhesive means into contact with the circuit component (15) in order to secure the side face of the circuit component (15) to the attachment member (14).

2. Circuit component locating apparatus according to claim 1, wherein the fastening frame (12) comprises a portion of a circuit board.

3. Circuit component locating apparatus according to claims 1 and 2, wherein the fastening frame (12) comprises a plurality of members connected to form a framework capable of being fastened to a circuit board.

4. Circuit component locating apparatus according to any preceding claim, wherein the attachment member (14) extends all of the way around the component (15).

5. Circuit component locating apparatus according to any preceding claim, further comprising a cover plate (22) corresponding to the space between the attachment member (14) and the component (15), the cover plate (22) having a lower face corresponding with an upper surface of the ledge (16) such that when the cover plate (22) is placed into engagement with a lip of the attachment member (14), said adhesive is urged into the space and into communication with the attachment member (14) and the circuit component (15) in order to seal the top of the space between the attachment member (14) and the component (15) and provide an adhesive connection there between.

6. Circuit component locating apparatus according to claim 5, wherein the cover plate (22) is adapted to snap fit into securing engagement with the attachment member (14) and circuit component (15).

7. Circuit component locating apparatus according to either of claims 5 or 6, wherein the cover plate (22) is integrated into the apparatus by way of a hinge member which allows the cover plate (22) to hinge from a first storage position to a second active position.

8. A method of locating a circuit component on a circuit board, the method comprising:
providing a fastening frame (12) having an attachment member (14) having an aperture, and projecting therefrom;
placing the attachment member (14) at least partially around a side face of the located circuit component (15) such that the attachment member (14) is spaced apart from the located circuit component (15) in order to define a space between the attachment member (14) and said side face of the circuit component (15), **characterised in that** the method further comprises providing adhesive means in the space between the attachment member (14) and said side face of the circuit component (15), providing an angled ledge (16) relative to the longitudinal axis of the aperture on the attachment member (14), for urging the adhesive means into contact with the circuit components (15) in order to secure the side face of the circuit component (15) to the attachment member (14).

9. A method according to claim 8, further comprising forming the fastening frame (12) from a plurality of members connected to form a framework capable of being fastened to a circuit board.

10. A method according to claims 8 and 9, further comprising the step of forming the attachment member (14) such that in use it extends all of the way around the component (15).

11. A method according to any of claims 8 to 10, further comprising
placing a cover plate (22) corresponding to the space between the attachment member (14) and the component (15) and having a lower face corresponding with an upper surface of the ledge (16) into engagement with a lip of the attachment member (14), such that said adhesive is urged into the space and into communication with the attachment member (14) and the circuit component (15) in order to seal the top of the space between the attachment member (14) and the component (15) and provide an adhesive connection there between.

12. A method according to claim 11, wherein the step of placing the cover plate over the space further comprises hinging the cover plate from a first storage position to a second active position and into snapping engagement.

13. Circuit component locating apparatus according to claim 1, further comprising a cover plate (22) corresponding to the space between the attachment member (14) and the component (15), the cover plate (22) having a lower face corresponding with an upper surface of the ledge (16) such that when the cover plate (22) is placed into engagement with a lip of the attachment member (14), said adhesive is urged into the space and into communication with the attachment member (14) and the circuit component (15) in order to seal the top of the space between the attachment member (14) and the component (15) and provide an adhesive connection there between.

14. Circuit component locating apparatus according to claim 13, wherein the fastening frame (12) comprises a portion of a circuit board.

15. Circuit component locating apparatus according to claims 13 and 14, wherein the fastening frame (12) comprises a plurality of members connected to form a framework capable of being fastened to a circuit board.

16. Circuit component locating apparatus according to claims 13 to 15, wherein the attachment member (14) extends all of the way around the component (15).

17. Circuit component locating apparatus according to claims 13 to 16, wherein the cover plate (22) is adapted to snap fit into securing engagement with the attachment member (14) and circuit component (15).

18. Circuit component locating apparatus according to claims 13 to 17, wherein the cover plate (22) is integrated into the apparatus by way of a hinge member which allows the cover plate (22) to hinge from a first storage position to a second active position.

19. A method according to claim 8, further comprising placing a cover plate (22), having a lower face corresponding with an upper surface of the ledge (16), over the space between the attachment member (14) and the component (15) such that when the cover plate (22) is placed into engagement with a lip of the attachment member (14), said adhesive means is urged into the space and into communication with the attachment member (14) and the circuit component (15) in order to seal the top of the space between the attachment member (14) and the component (15) and provide an adhesive connection there between.

## Patentansprüche

1. Schaltungskomponente-Anordnungsvorrichtung zum Anordnen einer Schaltungskomponente auf einer Leiterplatte, wobei die Schaltungskomponente-Anordnungsvorrichtung aufweist:
einen Halterungsrahmen (12);
ein Befestigungs- bzw. Halterungselement (14), das aus dem Halterungsrahmen (12) herausragt, eine Öffnung hat und sich, bei Verwendung, zumindest teilweise um eine Seitenfläche der angeordneten Schaltungskomponente (15) erstreckt, wobei, bei Verwendung, das Halterungselement (14) mit Abstand von der angeordneten Schaltungskomponente (15) vorgesehen ist, um einen Zwischenraum zwischen dem Halterungselement (14) und der Seitenfläche der Schaltungskomponente (15) zu definieren, **dadurch gekennzeichnet, dass** der Zwischenraum Haft- bzw. Klebemittel aufnehmen kann und das Halterungselement (14) relativ zu der Längsachse der Öffnung abgewinkelt ist, um eine Leiste bzw. ein Sims (16) vorzusehen, um das Haftmittel in Kontakt mit der Schaltungskomponente (15) zu bringen, um die Seitenfläche der Schaltungskomponente (15) an dem Halterungselement (14) zu befestigen.

2. Schaltungskomponente-Anordnungsvorrichtung gemäß Anspruch 1, wobei der Halterungsrahmen (12) einen Teil einer Leiterplatte aufweist.

3. Schaltungskomponente-Anordnungsvorrichtung gemäß den Ansprüchen 1 und 2, wobei der Halterungsrahmen (12) eine Vielzahl von Elementen aufweist, die verbunden sind, um ein Rahmenwerk zu bilden, das an einer Leiterplatte befestigt werden kann.

4. Schaltungskomponente-Anordnungsvorrichtung gemäß einem vorhergehenden Anspruch, wobei sich das Halterungselement (14) ganz um die Komponente (15) herum erstreckt.

5. Schaltungskomponente-Anordnungsvorrichtung gemäß einem vorhergehenden Anspruch, die weiter aufweist eine Abdeckungsplatte (22), die dem Zwischenraum zwischen dem Halterungselement (14) und der Komponente (15) entspricht, wobei die Abdeckungsplatte (22) eine untere Fläche hat, die einer oberen Oberfläche der Leiste (16) derart entspricht, dass, wenn die Abdeckungsplatte (22) mit einem Rand des Halterungselements (14) in Eingriff gebracht wird, das Haftmittel in den Zwischenraum und in Verbindung mit dem Halterungselement (14) und der Schaltungskomponente (15) gebracht wird, um das obere Ende des Zwischenraums zwischen dem Halterungselement (14) und der Komponente (15) abzudichten und dazwischen eine Haftverbindung vorzusehen.

6. Schaltungskomponente-Anordnungsvorrichtung gemäß Anspruch 5, wobei die Abdeckungsplatte (22) ausgebildet ist, in einen sicheren Eingriff mit dem Halterungselement (14) und der Schaltungskomponente (15) einzurasten.

7. Schaltungskomponente-Anordnungsvorrichtung gemäß einem der Ansprüche 5 oder 6, wobei die Abdeckungsplatte (22) in die Vorrichtung integriert ist über ein Gelenkelement, das ermöglicht, dass die Abdeckungsplatte (22) von einer ersten Lageposition in eine zweite aktive Position gebracht wird.

8. Verfahren zum Anordnen einer Schaltungskomponente auf einer Leiterplatte, wobei das Verfahren aufweist:
Vorsehen eines Halterungsrahmens (12) mit einem Befestigungs- bzw. Halterungselement (14), das eine Öffnung hat und daraus herausragt;
Platzieren des Halterungselements (14) zumindest teilweise um eine Seitenfläche der angeordneten Schaltungskomponente (15), so dass das Halterungselement (14) mit Abstand von dem angeordneten Schaltungskomponente (15) vorgesehen ist, um einen Zwischenraum zwischen dem Halterungselement (14) und der Seitenfläche der Schaltungskomponente (15) zu definieren, **dadurch gekennzeichnet, dass** das Verfahren weiter aufweist ein Vorsehen von Haft- bzw. Klebemitteln in dem Zwischenraum zwischen dem Halterungselement (14) und der Seitenfläche der Schaltungskomponente (15), Vorsehen einer abgewinkelten Leiste (16) relativ zu der Längsachse der Öffnung in dem Halterungselement (14), um das Haftmittel in Kontakt mit der Schaltungskomponente (15) zu bringen, um die Seitenfläche der Schaltungskomponente (15) an dem Halterungselement (14) zu befestigen.

9. Verfahren gemäß Anspruch 8, das weiter aufweist Ausbilden des Halterungsrahmens (12) aus einer Vielzahl von Elementen, die verbunden sind, um ein Rahmenwerk zu bilden, das an einer Leiterplatte befestigt werden kann.

10. Verfahren gemäß den Ansprüchen 8 und 9, das weiter aufweist den Schritt eines Ausbildens des Halterungselements (14) derart, dass es sich, bei Verwendung, ganz um die Komponente (15) herum erstreckt.

11. Verfahren gemäß einem der Ansprüche 8 bis 10, das weiter aufweist Platzieren einer Abdeckungsplatte (22), die dem Zwischenraum zwischen dem Halterungselement (14) und der Komponente (15) entspricht und eine untere Fläche hat, die einer oberen Oberfläche der Leiste (16) entspricht, in Eingriff mit einem Rand des Halterungselements (14) derart, dass das Haftmittel in den Zwischenraum und in Verbindung mit dem Halterungselement (14) und der Schaltungskomponente (15) gebracht wird, um das obere Ende des Zwischenraums zwischen dem Halterungselement (14) und der Komponente (15) abzudichten und dazwischen eine Haftverbindung vorzusehen.

12. Verfahren gemäß Anspruch 11, wobei der Schritt des Platzierens der Abdeckungsplatte über den Zwischenraum weiter aufweist ein Bringen der Abdeckungsplatte von einer ersten Lageposition in eine zweite aktive Position und in einen Einrasteingriff.

13. Schaltungskomponente-Anordnungsvorrichtung gemäß Anspruch 1, die weiter aufweist eine Abdeckungsplatte (22), die dem Zwischenraum zwischen dem Halterungselement (14) und der Komponente (15) entspricht, wobei die Abdeckungsplatte (22) eine untere Fläche hat, die einer oberen Oberfläche der Leiste (16) derart entspricht, dass, wenn die Abdeckungsplatte (22) mit einem Rand des Halterungselements (14) in Eingriff gebracht wird, das Haftmittel in den Zwischenraum und in Verbindung mit dem Halterungselement (14) und der Schaltungskomponente (15) gebracht wird, um das obere Ende des Zwischenraums zwischen dem Halterungselement (14) und der Komponente (15) abzudichten und dazwischen eine Haftverbindung vorzusehen.

14. Schaltungskomponente-Anordnungsvorrichtung gemäß Anspruch 13, wobei der Halterungsrahmen (12) einen Teil einer Leiterplatte aufweist.

15. Schaltungskomponente-Anordnungsvorrichtung gemäß den Ansprüchen 13 und 14, wobei der Halterungsrahmen (12) eine Vielzahl von Elementen aufweist, die verbunden sind, um ein Rahmenwerk zu bilden, das an einer Leiterplatte befestigt werden kann.

16. Schaltungskomponente-Anordnungsvorrichtung gemäß den Ansprüchen 13 bis 15, wobei sich das Halterungselement (14) ganz um die Komponente (15) herum erstreckt.

17. Schaltungskomponente-Anordnungsvorrichtung gemäß den Ansprüchen 13 bis 16, wobei die Abdeckungsplatte (22) ausgebildet ist, in einen sicheren Eingriff mit dem Halterungselement (14) und der Schaltungskomponente (15) einzurasten.

18. Schaltungskomponente-Anordnungsvorrichtung gemäß den Ansprüchen 13 bis 17, wobei die Abdeckungsplatte (22) in die Vorrichtung integriert ist über ein Gelenkelement, das ermöglicht, dass die Abdeckungsplatte (22) von einer ersten Lageposition in eine zweite aktive Position gebracht wird.

19. Verfahren gemäß Anspruch 8, das weiter aufweist
Platzieren einer Abdeckungsplatte (22), die eine untere Fläche hat, die einer oberen Oberfläche der Leiste (16) entspricht, über den Zwischenraum zwischen dem Halterungselement (14) und der Komponente (15) derart, dass, wenn die Abdeckungsplatte (22) in Eingriff mit einem Rand des Halterungselements (14) platziert ist, das Haftmittel in den Zwischenraum und in Verbindung mit dem Halterungselement (14) und der Schaltungskomponente (15) gebracht wird, um das obere Ende des Zwischenraums zwischen dem Halterungselement (14) und der Komponente (15) abzudichten und dazwischen eine Haftverbindung vorzusehen.

## Revendications

1. Appareil de localisation pour composant de circuits destiné à localiser un composant de circuits sur une carte à circuits, l'appareil de localisation pour composant de circuits comprenant :
un cadre de fixation (12) ;
un élément d'attache (14) qui se projette depuis le cadre de fixation (12), ayant une ouverture, et s'étendant en utilisation au moins partiellement autour d'une face latérale du composant de circuits localisé (15), de sorte qu'en utilisation l'élément d'attache (14) est espacé depuis le composant de circuits localisé (15) afin de définir un espace entre l'élément d'attache (14) et ladite face latérale du composant de circuits (15), **caractérisé en ce que** l'espace est capable de recevoir des moyens adhésifs, et l'élément d'attache (14) est disposé sous un angle par rapport à l'axe longitudinal de l'ouverture afin de constituer un rebord (16) pour forcer les moyens adhésifs en contact avec le composant de circuits (15) afin d'attacher la face latérale du composant de circuits (15) sur l'élément d'attache (14).

2. Appareil de localisation pour composant de circuits selon la revendication 1, dans lequel le cadre de fixation (12) comprend une portion d'une carte à circuits.

3. Appareil de localisation pour composant de circuits selon les revendications 1 et 2, dans lequel le cadre de fixation (12) comprend une pluralité d'éléments connectés pour former une ossature capable d'être fixée sur une carte à circuits.

4. Appareil de localisation pour composant de circuits selon l'une quelconque des revendications précédentes, dans lequel l'élément d'attache (14) s'étend tout autour du composant (15).

5. Appareil de localisation pour composant de circuits selon l'une quelconque des revendications précédentes, comprenant en outre une plaque de couverture (22) correspondant à l'espace entre l'élément d'attache (14) et le composant (15), la plaque de couverture (22) ayant une face inférieure correspondant à une surface supérieure du rebord (16) de telle sorte que lorsque la plaque de couverture (22) est placée en engagement avec une lèvre de l'élément d'attache (14), ledit adhésif est forcé dans l'espace et en communication avec l'élément d'attache (14) et avec le composant de circuits (15) afin de sceller le sommet de l'espace entre l'élément d'attache (14) et le composant (15) et d'assurer une connexion adhésive entre eux.

6. Appareil de localisation pour composant de circuits selon la revendication 5, dans lequel la plaque de couverture (22) est adaptée à s'engager avec encliquetage en engagement de fixation avec l'élément d'attache (14) et avec le composant de circuits (15).

7. Appareil de localisation pour composant de circuits selon l'une ou l'autre des revendications 5 ou 6, dans lequel la plaque de couverture (22) est intégrée dans l'appareil au moyen d'un élément à charnière qui permet à la plaque de couverture (22) de pivoter depuis une première position de stockage jusqu'à une seconde position active.

8. Procédé pour localiser un composant de circuits sur une carte à circuits, le procédé comprenant les opérations suivantes :
fourniture d'un cadre de fixation (12) ayant un élément d'attache (14) ayant une ouverture et se projetant de celui-ci ;
mise en place de l'élément d'attache (14) au moins partiellement autour d'une face latérale du composant de circuits localisés (15) de sorte que l'élément d'attache (14) est espacé depuis le composant de circuits localisé (15) afin de définir un espace entre l'élément d'attache (14) et ladite face latérale du composant de circuits (15), **caractérisé en ce que** le procédé comprend en outre les opérations consistant à
fournir des moyens adhésifs dans l'espace entre l'élément d'attache (14) et ladite face latérale du composant de circuits (15), fournir un rebord en angle (16) par rapport à l'axe longitudinal de l'ouverture sur l'élément d'attache (14), pour forcer les moyens adhésifs en contact avec le composant de circuits (15) afin de fixer la face latérale du composant de circuits (15) sur l'élément d'attache (14).

9. Procédé selon la revendication 8, comprenant en outre l'opération consistant à former le cadre de fixation (12) à partir d'une pluralité d'éléments connectés pour former une ossature capable d'être fixée sur une carte à circuits.

10. Procédé selon les revendications 8 et 9, comprenant en outre l'étape consistant à former l'élément d'attache (14) de telle façon qu'en utilisation il s'étend tout autour du composant (15).

11. Procédé selon l'une quelconque des revendications 8 à 10, comprenant en outre l'opération consistant à placer une plaque de couverture (22) en correspondance de l'espace entre l'élément d'attache (14) et le composant (15) et ayant une face inférieure correspondant à une surface supérieure du rebord (16) en engagement avec une lèvre de l'élément d'attache (14), de sorte que ledit adhésif est forcé dans l'espace et en communication avec l'élément d'attache (14) et avec le composant de circuits (15) afin de sceller le sommet de l'espace entre l'élément d'attache (14) et le composant (15) et assurer une connexion adhésive entre eux.

12. Procédé selon la revendication 11, dans lequel l'étape consistant à mettre en place la plaque de couverture au-dessus de l'espace comprend en outre de faire pivoter la plaque de couverture depuis une première position de stockage jusqu'à une seconde position active et en engagement par encliquetage.

13. Appareil de localisation pour composant de circuits selon la revendication 1, comprenant en outre
une plaque de couverture (22) correspondant à l'espace entre l'élément d'attache (14) et le composant (15), la plaque de couverture (22) ayant une face inférieure correspondant avec une surface supérieure du rebord (16) de telle façon que lorsque la plaque de couverture (22) est placée en engagement avec une lèvre de l'élément d'attache (14), ledit adhésif est forcé dans l'espace et en communication avec l'élément d'attache (14) et avec le composant de circuits (15) afin de sceller le sommet de l'espace entre l'élément d'attache (14) et le composant (15) et assurer une connexion adhésive entre eux.

14. Appareil de localisation pour composant de circuits selon la revendication 13, dans lequel le cadre de fixation (12) comprend une portion d'une carte à circuits.

15. Appareil de localisation pour composant de circuits selon les revendications 13 et 14, dans lequel le cadre de fixation (12) comprend une pluralité d'éléments connectés pour former une ossature capable d'être fixée sur une carte à circuits.

16. Appareil de localisation pour composant de circuits selon les revendications 13 à 15, dans lequel l'élément d'attache (14) s'étend tout autour du composant (15).

17. Appareil de localisation pour composant de circuits selon les revendications 13 à 16, dans lequel la plaque de couverture (22) est adaptée à s'encliqueter en engagement de fixation avec l'élément d'attache (14) et avec le composant de circuits (15).

18. Appareil de localisation pour composant de circuits selon les revendications 13 à 17,
dans lequel la plaque de couverture (22) est intégrée dans l'appareil au moyen d'un élément de charnière qui permet à la plaque de couverture (22) de pivoter de puis une première position de stockage jusqu'à une seconde position active.

19. Procédé selon la revendication 8, comprenant en outre l'étape consistant à
placer une plaque de couverture (22), ayant une face inférieure correspondant avec une surface supérieure du rebord (16), par-dessus l'espace entre l'élément d'attache (14) et le composant (15) de telle façon que, lorsque la plaque de couverture (22) est placée en engagement avec une lèvre de l'élément d'attache (14), lesdits moyens adhésifs sont forcés dans l'espace et en communication avec l'élément d'attache (14) et avec le composant de circuits (15) afin de sceller le sommet de l'espace entre l'élément d'attache (14) et le composant (15), et d'assurer une connexion adhésive entre eux.
